# FASCICULE DE BREVET EUROPEEN

(11) **EP 0 404 656 B1**
(45) Date de publication et mention de la délivrance du brevet: **06.04.1994**
(21) Numéro de dépôt: 90401708.4
(22) Date de dépôt: 19.06.1990
(51) Int. Cl.: B02C 4/28, B02C 4/02, B02C 4/30

(54) **Procédé de broyage fin de minéraux et broyeur pour la mise en oeuvre de ce procédé**
Feinzerkleinerungsverfahren für Mineralien und Zerkleinerer zur Durchführung des Verfahrens
Mineral fine-pulverising method and pulveriser for carrying out this method

(30) Priorité: 20.06.1989 FR 8908165
(43) Date de publication de la demande: 27.12.1990
(73) Titulaire: F C B, 93107 Montreuil Cédex (FR)
(72) Inventeur: Durinck, René, F-59650 Villeneuve d'Ascq (FR); Lagache, Philippe, F-59700 Marcq-en-Baroeul (FR); Cordonnier, Alain, F-59800 Lille (FR)
(74) Mandataire: Fontanié, Etienne

(56) Documents cités:
- EP-A- 0 308 350
- EP-A- 0 328 647
- DE-C- 457 037
- FR-A- 447 316
- FR-A- 453 735
- FR-A- 460 333

## Description

La présente invention a pour objet un broyeur pour le broyage fin des minéraux comportant deux cylindres à axes horizontaux et parallèles, tournant en sens inverses et poussés élastiquement l'un vers l'autre, et un barrage placé au-dessous du plan contenant les axes des cylindres et fermant vers le bas l'espace délimité par les cylindres au-dessous de ce plan et laissant subsister un passage de section réduite pour la sortie des produits broyés.

Un tel broyeur fait l'objet de la demande de brevet français publiée sous le n° 2620635. Il permet de maintenir la matière broyée en pression dans l'espace délimité par les cylindres immédiatement au-dessous du plan fictif contenant les axes des cylindres. La contrepression que la matière broyée exerce sous le plan des axes des cylindres sur la section de la couche de matière compactée par passage entre les cylindres, provoque la décohésion des particules par effet de cisaillement, en raison de l'anisotropie de la couche de matière, et combat la formation d'agglomérats.

Dans le brevet français n° 460333, relatif à la mouture des gruaux, on a proposé de créer une contrepression s'opposant à la poussée de la matière sortant des cylindres en plaçant entre les cylindres, du côté de la sortie, une trémie fermée par un volet soumis à la force d'un ressort ou d'un contrepoids.

Les solutions décrites dans les documents précités ne permettent pas d'assurer une fermeture correcte de l'espace entre cylindres, au-dessous du plan des axes des cylindres, notamment à ses extrémités.

On connaît par ailleurs (DE.C.457037) un broyeur dont les cylindres comportent des joues qui ferment l'espace entre cylindres, à ses extrémités. Ces joues remplacent les joues fixes habituellement utilisées pour empêcher la matière à broyer de s'échapper latéralement, aux extrémités des cylindres.

Le but de la présente invention est de fournir un broyeur à cylindres dans lequel l'espace entre cylindres, au-dessous du plan des axes des cylindres, est mieux fermé de façon à ce que la contrepression s'exerce de manière uniforme sur toute la section de la fente entre cylindres, et de façon à empêcher le fusage circonférentiel et/ou latéral de la matière lorsque celle-ci contient un pourcentage élevé de fines particules, ce qui est notamment le cas lorsque le produit broyé est recyclé.

Le broyeur objet de la présente invention est caractérisé en ce que l'un des cylindres est muni à ses extrémités de deux joues annulaires situées de part et d'autre de l'autre cylindre, à faible distance des faces d'extrémité de ce dernier, en ce que deux joues fixes, situées dans les mêmes plans que les joues annulaires et dont le bord suit avec un faible jeu le bord circulaire de ces dernières, s'étendent vers le bas depuis le plan des axes des cylindres jusqu'au niveau du barrage, et en ce que ledit barrage est constitué, au moins en partie, par une barre de raclage placée au contact de la surface périphérique du cylindre muni des joues et de la surface intérieur de ces joues. La barre de raclage sera poussée élastiquement vers l'autre cylindre. En variante, le barrage pourra être constitué par une barre de raclage et par un rouleau dont l'axe est parallèle aux axes des cylindres, la barre et le rouleau étant disposés côte-à-côte et le rouleau étant poussé élastiquement vers l'autre cylindre en laissant subsister entre eux un passage pour la sortie des produits broyés.

Les caractéristiques de l'invention apparaîtront plus clairement à la lecture de la description qui suit et se réfère aux dessins l'accompagnant qui montrent, à titre d'exemple non limitatif, deux formes de réalisation de l'invention et sur lesquels :
- La figure 1 est une vue en coupe transversale d'un broyeur à cylindres conforme à l'invention;
- Les figures 1 A et 1 B sont des coupes suivant X - X et A - A, respectivement;
- La figure 2 est une vue de côté du broyeur; et

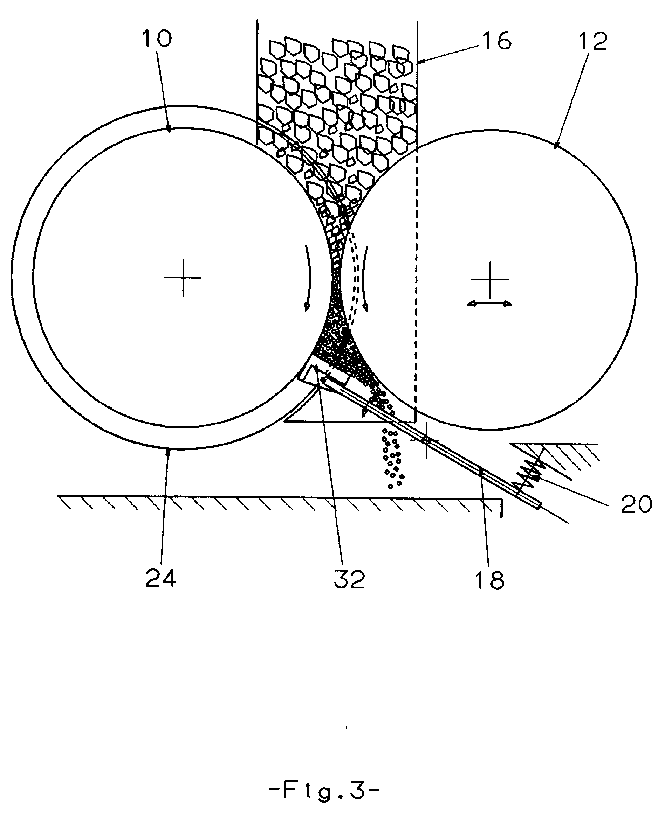

- La figure 3 est une vue en coupe transversale illustrant une variante.

Le broyeur représenté sur les dessins est constitué essentiellement par deux cylindres identiques 10 et 12, à axes horizontaux et parallèles. Les paliers du cylindre 10 sont fixes et les paliers de l'autre cylindre 12 sont montés sur des glissières ou des bras pivotants pour permettre à ce cylindre de se rapprocher et de s'écarter du premier. Le cylindre 12 est poussé élastiquement vers le cylindre 10 par des ressorts ou au moyen d'un système hydro-pneumatique. Les deux cylindres sont entraînés en rotation à la même vitesse et en sens inverses.

Au repos, l'écartement entre les cylindres 10 et 12 est maintenu à une valeur minimale par des butées. En marche, la matière à broyer est mise en charge au-dessus des cylindres dans une goulotte d'alimentation 16, et le débit d'alimentation est nettement supérieur au débit correspondant à l'écartement minimal, de sorte que les cylindres sont maintenus à un écartement supérieur par la couche de matière qui se forme entre eux. Au sein de cette couche, le broyage est réalisé non seulement par écrasement, sous l'action de la pression exercée par les cylindres, mais aussi par attrition entre particules, de sorte que le produit broyé contient une forte proportion de fines particules.

Le cylindre 10 est muni à ses extrémités de joues annulaires 24 qui encadrent le cylindre 12, un faible jeu étant ménagé entre les joues et les faces d'extrémité du cylindre 12. Ces joues peuvent être formées par usinage dans la masse du cylindre ou être rapportées sur le cylindre et maintenues mécaniquement sur celui-ci. Elles ferment à ses deux extrémités l'espace entre les cylindres, au-dessus et au-dessous du plan X - X contenant les axes des cylindres, et au moins dans la zone de plus forte pression exercée sur la matière par les cylindres; la fermeture latérale de cet espace est complétée vers le bas par des joues fixes 30 qui prolongent les faces latérales de la trémie 16 et sont situées dans le plan des joues 24 en entourant leur bord extérieur avec un jeu minimum.

Une barre 26 placée au contact de la surface périphérique du cylindre 10, le long d'une génératrice, et de la surface intérieure des joues 24, ou à très faible distance de ces surfaces, assure le nettoyage du cylindre et des joues. Cette barre est montée sur un support fixe 28 de telle sorte que sa position par rapport au cylindre 10 puisse être ajustée, en particulier pour compenser l'usure.

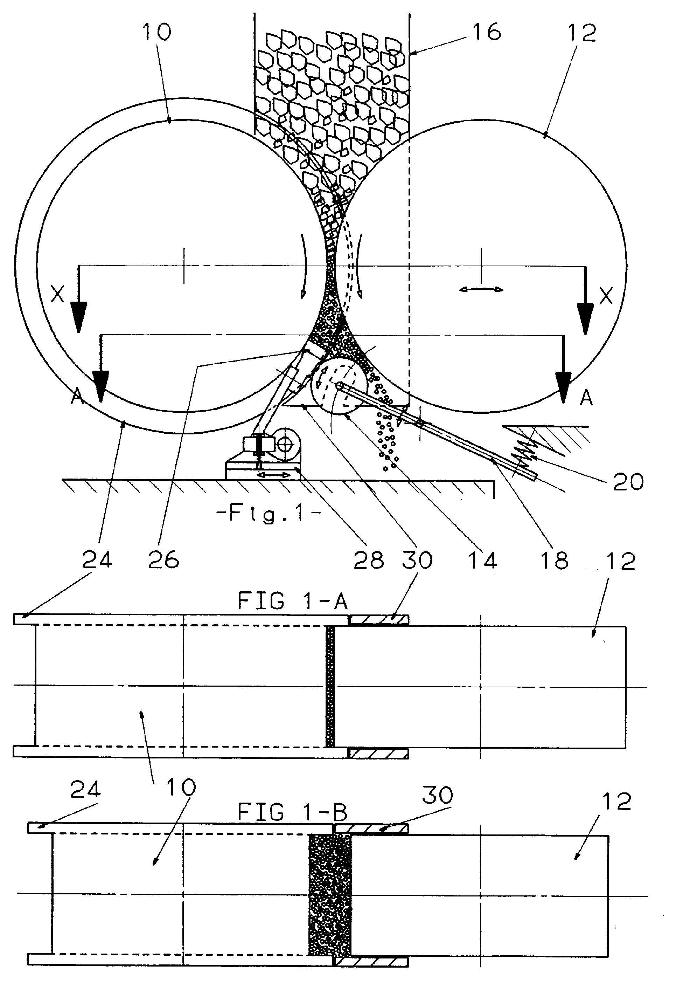

Un rouleau 14 de petit diamètre est placé sous les cylindres, à côté de la barre 26. Ces deux éléments sont représentés non coupés sur la figure 1. Les paliers de ce rouleau sont supportés par deux bras 18 pouvant pivoter autour d'un axe parallèle aux axes des cylindres, de manière à ce que, dans toutes les conditions de travail, le rouleau puisse prendre une position d'équilibre par rapport au cylindre 12 en étant poussé vers celui-ci par un dispositif élastique tel que des ressorts 20. La forme de la section droite de la barre 26 est choisie pour que, dans toutes les positions de travail du rouleau 14, la distance entre celui-ci et la face ajacente de la barre reste faible et sensiblement constante. La position de l'axe d'articulation des bras 18 est réglable pour compenser l'usure du rouleau 14 et de la barre 26.

L'espace délimité sous le plan X - X par les cylindres 10 et 12, les joues 24 et 30, la barre 26 et le rouleau 14 ne débouche sur l'extérieur que par la fente ménagée entre le cylindre 12 et le rouleau 14, et il est possible de maintenir la matière broyée en pression dans cet espace, en contrôlant l'effort exercé par les ressorts 20, de telle sorte que le produit broyé ne contiennent pratiquement pas d'agglomérats. La contrepression de la matière broyée sortante s'exerce sur la section de la couche au niveau de l'entrefer (fente entre les cylindres dans le plan X - X) et provoque sa décohésion au fur et à mesure de son avancement.

Le dispositif de l'invention a aussi un rôle anti-fusage de la matière lorsqu'elle contient des particules dont les dimensions sont très nettement inférieures à l'écartement entre cylindres dans le plan X - X, c'est-à-dire qu'il évite que ces fines particules ne se déplacent dans la couche de matière à une vitesse supérieure à la vitesse périphérique des cylindres ou s'échappent latéralement, sans être soumises à des efforts de broyage. Ces conditions se rencontrent en particulier lorsque le produit broyé est recyclé, éventuellement après passage dans un appareil de classification pour séparer les particules les plus fines.

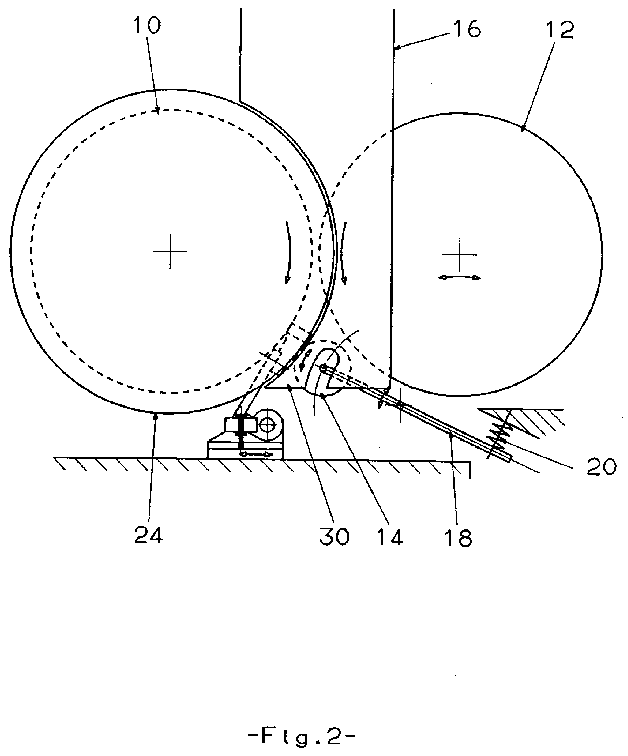

Le broyeur de la figure se distingue essentiellement de celui représenté sur les figures 1 et 2 par le fait que l'ensemble barre 26 - rouleau 14 a été remplacé par une barre 32 de forme et de dimensions appropriées, cette barre étant montée de la même manière que le rouleau 14 sur des bras oscillants 18 sollicités par des ressorts 20 et servant également de racleur pour le cylindre 10.

Comme indiqué plus haut, les joues 24 pourraient être supprimées et l'espace délimité par les cylindres sous le plan de leurs axes pourrait être fermé latéralement uniquement par des joues fixes disposées parallèlement aux faces d'extrémité des cylindres 10 et 12, à faible distance de celles-ci. On pourrait aussi fermer ledit espace à l'une de ses extrémités par une joue solidaire de l'un des cylindres et à son extrémité par une autre joue solidaire de l'autre cylindre.

## Revendications

1. Broyeur pour le broyage fin des minéraux comportant deux cylindres (10, 12) à axes horizontaux et parallèles, tournant en sens inverses et poussés élastiquement l'un vers l'autre, et un barrage placé au-dessous du plan contenant les axes des cylindres et fermant vers le bas l'espace délimité par les cylindres au-dessous de ce plan en laissant subsister un passage de section réduite pour la sortie des produits broyés, caractérisé en ce que l'un des cylindres (10) est muni à ses extrémités de deux joues annulaires (24) situées de part et d'autre de l'autre cylindre, à faible distance des faces d'extrémité de ce dernier, en ce que deux joues fixes (30), situées dans les mêmes plans que les joues annulaires et dont le bord suit avec un faible jeu le bord circulaire de ces dernières, s'étendent vers le bas depuis le plan des axes des cylindres jusqu'au niveau dudit barrage, et en ce que ledit barrage est constitué, au moins en partie, par une barre de raclage (26, 32) placée au contact de la surface périphérique du cylindre (10) muni des joues (24) et de la surface intérieure de ces joues.

2. Broyeur selon la revendication 1, caractérisé en ce que ledit barrage est constitué par la barre de raclage (26) et un rouleau (14) dont l'axe est parallèle aux axes des cylindres, en ce que la barre et le rouleau sont disposés côte-à-côte, et en ce qu'un passage est ménagé entre ledit rouleau et l'autre cylindre (12) pour la sortie des produits broyés.

3. Broyeur selon la revendication 1, caractérisé en ce que la barre de raclage (32) est poussée élastiquement vers l'autre cylindre (12).

4. Broyeur selon la revendication 2, caractérisé en ce que ledit rouleau (14) est poussé élastiquement vers l'autre cylindre (12).

## Patentansprüche

1. Mühle zur Feinmahlung von Mineralien, welche zwei Walzen (10, 12) mit horizontalen und parallel angeordneten Achsen umfaßt, die gegenläufig rotieren und elastisch aneinander gedrückt werden, und eine unterhalb der die Walzenachsen enthaltenden Ebene angeordnete Sperre, welche den von den Walzen abgegrenzten Raum unterhalb dieser Ebene nach unten hin verschließt und einen Durchgang mit verringertem Querschnitt zum Auslaß des gemahlenen Produktes freiläßt, dadurch gekennzeichnet, daß eine der Walzen (10) an ihren Enden mit zwei ringförmigen Wangen (24) versehen ist, die beiderseitig der anderen Walze im geringen Abstand von ihren Stirnseiten zu liegen kommen, daß sich zwei ortsfeste Wangen (30), die in denselben Ebenen wie die ringförmigen Wangen angeordnet sind und deren Kante der ringförmigen Kante letzterer mit einem geringen Spiel folgt, von der Ebene der Walzenachsen nach unten hin bis auf die Höhe besagter Sperre ausdehen, und daß besagte Sperre mindestens teilweise aus einer Abstreifstange (26, 32) besteht, die mit der Umfangsfläche der mit den Wangen (24) versehenen Walze (10) und mit der Innenfläche der Wangen in Berührung gebracht wird.

2. Mühle gemäß Anspruch 1, dadurch gekennzeichnet, daß besagte Sperre aus einer Abstreifstange (26) und einer Rolle (14) besteht, deren Achse parallel zu den Walzenachsen verläuft, daß die Stange und die Rolle nebeneinander angeordnet sind, und daß zwischen besagter Rolle und der anderen Walze (12) ein Durchgang zum Auslaß des gemahlenen Produktes vorgesehen ist.

3. Mühle gemäß Anspruch 1, dadurch gekennzeichnet, daß die Abstreifstange (32) elastisch zur anderen Walze (12) hin gedrückt wird.

4. Mühle gemäß Anspruch 2, dadurch gekennzeichnet, daß besagte Rolle (14) elastisch zur anderen Walze (12) hin gedrückt wird.

## Claims

1. Grinding mill for fine grinding of minerals, including two rolls (10, 12) with horizontal and parallel axes which rotate in opposite directions and are elastically pushed against each other, and a barrier arranged below the plane containing the roll axes which closes the bottom of the space delimited by the rolls under this plane while leaving a small cross-section passage for the outlet of the ground products, characterized in that one of the rolls (10) is fitted at its ends with annular cheeks (24) arranged on either side of the other roll at a short distance from the end faces of the latter, in that two stationary cheeks (30) arranged in the same planes as the annular cheeks and the edge of which follows the circular edge of the latter with a small clearance extend from the plane of the roll axes down to the level of the said barrier, and in that the said barrier is composed, at least partly, of a scraper bar (26, 32) brought into contact with the peripheral surface of the roll (10) fitted with the cheeks (24) and with the inner surface of these cheeks.

2. Grinding mill according to claim 1, characterized in that the said barrier is composed of a scraper bar (26) and a roller (14) the axis of which is parallel to the roll axes, in that the bar and the roller are arranged side by side, and in that a passage is provided between the said roller and the other roll (12) for the outlet of the ground products.

3. Grinding mill according to claim 1, characterized in that the scraper bar (32) is elastically pushed toward the other roll (12).

4. Grinding mill according to claim 2, characterized in that the said roller (14) is elastically pushed toward the other roll (12).
